# EUROPEAN PATENT APPLICATION

(11) **EP 4 772 913 A1**
(43) Date of publication of application: **08.07.2026**
(21) Application number: 24860453.0
(22) Date of filing: 30.08.2024
(51) Int. Cl.: G01T 1/24, H10F 30/00, G01T 1/02

(54) **X-RAY DETECTOR**

(30) Priority: 01.09.2023 KR 20230116148
(71) Applicant: Rayence Co., Ltd., Hwaseong-si, Gyeonggi-do 18449 (KR); Vatech Ewoo Holdings Co., Ltd., Hwaseong-si, Gyeonggi-do 18449 (KR)
(72) Inventor: KIM, Jung Do, Hwaseong-si Gyeonggi-do 18449 (KR); LEE, Jin Sung, Hwaseong-si Gyeonggi-do 18449 (KR)
(74) Representative: Lorenz & Kollegen
(86) International application number: PCT/KR2024/013040
(87) International publication number: WO 2025/048535

(57) **Abstract**

The present invention provides an X-ray detector comprising: a sensor substrate; a sensor assembly including a phosphor layer or a photoelectric material layer and disposed on the front surface of the sensor substrate; a first waterproof film which coats the sensor assembly; and a second waterproof film which coats the first waterproof film and is made of a different material than the first waterproof film.

## Description

### Technical Field

The present disclosure relates to an X-ray detector.

### Background Art

In recent years, a digital type X-ray detector has become widely used for X-ray imaging.

An X-ray detector may experience performance degradation when moisture, oil, and so on penetrate into an inner portion of the X-ray detector. In order to prevent such performance degradation, a sealing structure is applied, but there is a problem that the existing sealing structure does not have sufficient moisture or oil prevention characteristics.

### Disclosure

### Technical Problem

Accordingly, the present disclosure has been made keeping in mind the above problems occurring in the related art, and an objective of the present disclosure is to provide an X-ray detector having a sealing structure capable of effectively preventing moisture or oil penetration.

### Technical Solution

In order to achieve the objective of the present disclosure, according to the present disclosure, there is provided an X-ray detector including: a sensor assembly which includes a sensor substrate and which includes a phosphor layer or a photoelectric material layer disposed on a front surface of the sensor substrate; a first waterproof film coating the sensor assembly; and a second waterproof film coating the first waterproof film, the second waterproof film being formed of a material different from a material of the first waterproof film.

The first waterproof film may surround an entirety of the sensor assembly, and the second waterproof film may cover a front side of the first waterproof film.

The X-ray detector may further include an upper electrode formed below the phosphor layer or on the photoelectric material layer, and the upper electrode may extend outward from the phosphor layer or the photoelectric material layer.

One of the first waterproof film and the second waterproof film may be formed of parylene, and the other of the first waterproof film and the second waterproof film may be formed of silicone or epoxy.

The one of the first waterproof film and the second waterproof film that is formed of parylene may be configured as a single film of parylene C or a double film of parylene N and parylene C.

The X-ray detector may further include a sealant covering the phosphor layer or the photoelectric material layer.

The sealant may be formed of a metal material, and may be a common upper electrode configured to apply a bias voltage to the photoelectric material layer.

The X-ray detector may further include an electromagnetic wave shielding sheet attached along a surface of the sealant and a surface of the sensor assembly.

The X-ray detector may further include: a boot having an accommodation space into which the sensor assembly coated with the first water proof film and the second water proof film is inserted, the boot being formed of a waterproof material; and a filler filling the accommodation space into which the sensor assembly is inserted, the filler being formed of a waterproof material.

The X-ray detector may further include: a case including a first case and a second case that define an internal space where the boot into which the sensor assembly is inserted is accommodated; and a coupling member coupling the first case and the second case.

### Advantageous Effects

According to the present disclosure, the phosphor layer or the photoelectric material layer vulnerable to moisture may be surrounded by the plurality of sealing members and may be tightly sealed and, furthermore, the detector module sealed by the sealing members may be disposed in the boot and then may be filled and sealed with the filler.

As described above, since the X-ray detector includes the sealing structure capable of substantially completely and firmly sealing the phosphor layer or the photoelectric material layer, penetration of moisture or oil into the phosphor layer or the photoelectric material layer may be effectively prevented.

Accordingly, defects due to penetration of moisture or oil during a manufacturing process are prevented, thereby maximizing a yield of good products.

### Description of Drawings

FIG. 1 is a cross-sectional view schematically illustrating a configuration of an X-ray detector according to a first embodiment of the present disclosure.
FIG. 2 is a cross-sectional view schematically illustrating a detector module of the X-ray detector according to the first embodiment of the present disclosure.
FIG. 3 is a cross-sectional view schematically illustrating a sensor assembly and a sealing structure sealing the sensor assembly according to the first embodiment of the present disclosure.
FIG. 4 is a cross-sectional view schematically illustrating a structure including an upper electrode that extends outward from a phosphor layer in the X-ray detector according to the first embodiment of the present disclosure.
FIG. 5 is a cross-sectional view schematically illustrating a configuration of the X-ray detector according to a second embodiment of the present disclosure.
FIG. 6 is a cross-sectional view schematically illustrating the detector module of the X-ray detector according to the second embodiment of the present disclosure.
FIG. 7 is a cross-sectional view schematically illustrating the sensor assembly and the sealing structure sealing the sensor assembly according to the second embodiment of the present disclosure.
FIG. 8 is a cross-sectional view schematically illustrating a structure including the upper electrode that extends outward from a photoelectric material layer in the X-ray detector according to the second embodiment of the present disclosure.

### Mode for Invention

Hereinafter, embodiments of the present disclosure will be described in detail with reference to the drawings.

### <First Embodiment>

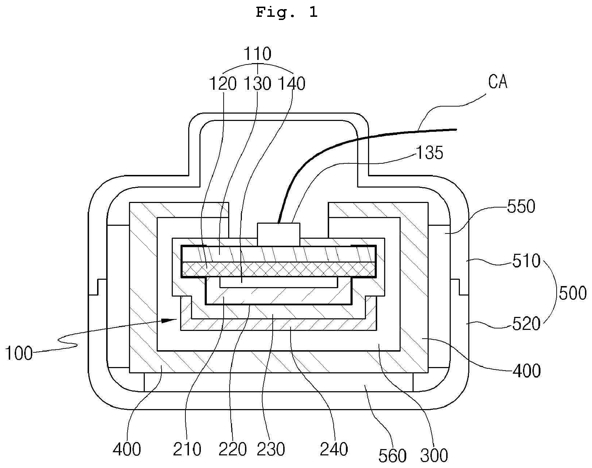

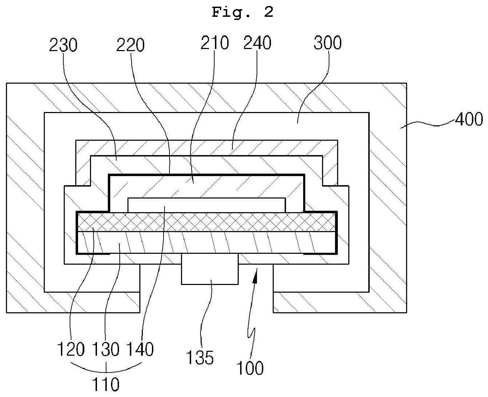

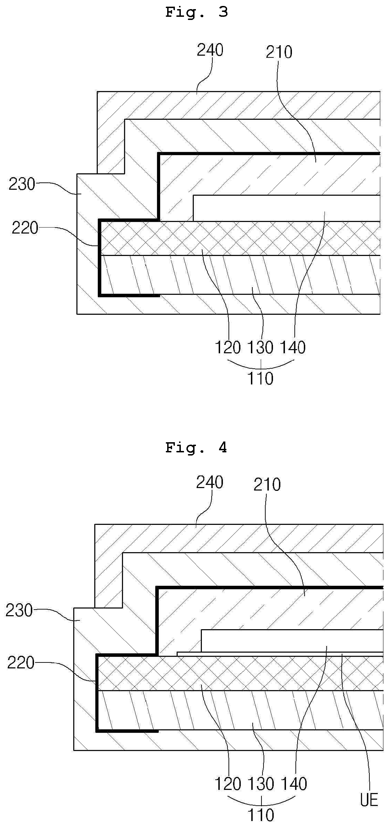

FIG. 1 is a cross-sectional view schematically illustrating a configuration of an X-ray detector according to a first embodiment of the present disclosure. FIG. 2 is a cross-sectional view schematically illustrating a detector module of the X-ray detector according to the first embodiment of the present disclosure. FIG. 3 is a cross-sectional view schematically illustrating a sensor assembly and a sealing structure sealing the sensor assembly according to the first embodiment of the present disclosure.

Referring to FIG. 1 to FIG. 3, an X-ray detector 10 according to the present embodiment may be configured as an indirect conversion type X-ray detector which converts incident X-rays into visible light and then converts the visible light into an electrical signal.

The X-ray detector 10 may include a detector module 100, a boot 400 (or a module cover), and a case 500 (or an outer case) .

Here, the detector module 100 may include a sensor assembly 110 and a plurality of sealing members sealing the sensor assembly 110.

First, the sensor assembly 110 may include a sensor substrate 120, a driving circuit board 130, and a phosphor layer 140.

The phosphor layer 140 may be disposed at a front side of the sensor substrate 120 in a direction in which X-rays are incident. In other words, the phosphor layer 140 may be disposed on an upper surface of the sensor substrate 120, i.e., the phosphor layer 140 may be disposed on a front surface of the sensor substrate 120. The phosphor layer 140 may convert incident X-rays into visible light.

The phosphor layer 140 may be formed of, for example, Cesium Iodide (CsI) or Gadolinium Oxysulfide (GoS or Gadox), but is not limited thereto.

For example, the phosphor layer 140 may be manufactured as a film form and may be attached to a light incident surface that is the upper surface of a sensor substrate 120. As another example, the phosphor layer 140 may be formed on the light incident surface of the sensor substrate 120 through a deposition process and so on.

The sensor substrate 120 may include an active area that is an area receiving and detecting visible light generated from the phosphor layer 140, and may include a non-active area positioned outside the active area. The sensor substrate 120 may be formed of a CMOS substrate or a TFT substrate.

Although not specifically illustrated, a pixel array in which a plurality of pixels is arranged may be provided in the active area of the sensor substrate 120, and the plurality of pixels may be arranged in a matrix form along a plurality of row lines and a plurality of column lines.

Each pixel may include a light detecting element (otherwise, a photodiode or an optical sensor) configured to detect incident visible light and to generate a corresponding electrical signal.

The driving circuit board 130 may be disposed at a rear side of the sensor substrate 120. In other words, the driving circuit board 130 may be positioned opposite to the phosphor layer 140 with the sensor substrate 120 interposed therebetween. A driving circuit for driving the sensor substrate 120 may be mounted on the driving circuit board 130.

Meanwhile, a connector 135 for connection with an external system circuit may be mounted on the driving circuit board 130. A cable CA may be connected to the connector 135, and the driving circuit board 130 may be electrically connected to the external system circuit through the cable CA.

As described above, the sensor assembly 110 according to the present embodiment may be configured as a stacked structure of the driving circuit board 130, the sensor substrate 120, and the phosphor layer 140.

Meanwhile, the phosphor layer 140 may be formed such that an edge of the front surface of the sensor substrate 120 is exposed. In other words, an edge area of the sensor substrate 120 is not covered by the phosphor layer 140, and a region inside the edge area may be covered by the phosphor layer 140.

In this regard, for example, the phosphor layer 140 may be disposed corresponding to the active area of the sensor substrate 120, and the non-active area positioned at an edge of the sensor substrate 120 may be exposed without being covered by the phosphor layer 140.

The sensor assembly 110 configured as described above may be configured to be sealed by the plurality of sealing members.

In this regard, for example, a sealant 210, a sealing tape (or an electromagnetic wave shielding sheet) 220, a first waterproof film (or a first coating film) 230, and a second waterproof film (or a second coating film) 240 may be disposed from the sensor assembly 110 toward an outward direction.

The sealant 210 may be formed such that the sealant 210 covers the phosphor layer 140. In this regard, for example, a sealant material may be deposited through a sputtering process in a vacuum state. In this manner, the sealant 210 may directly seal the phosphor layer 140.

Here, the sealant material may be a metal, for example, aluminum or gold, but is not limited thereto.

Accordingly, the sealant 210 may cover an upper surface and side surfaces of the phosphor layer 140, thereby sealing the phosphor layer 140 from the outside. Meanwhile, when the sealant 210 is formed in a vacuum state, additional penetration of moisture or oil may be prevented, and bubbles inside the phosphor layer 140 may be removed.

Meanwhile, in the present embodiment, as illustrated in FIG. 4, an upper electrode UE of the light detecting element may extend outward from below the phosphor layer 140. In this regard, the upper electrode UE of the light detecting element to which a bias voltage (or a reverse voltage) is applied may be formed substantially over the entire active area, and the upper electrode UE may extend outward from the phosphor layer 140 positioned above the upper electrode UE.

A portion of the upper electrode UE that extends outward in this manner may be covered by the sealant 210 and may be in contact with the sealant 210.

Accordingly, the phosphor layer 140 may be surrounded by the sealant 210 and the upper electrode UE, and may be in a completely sealed state. Through such a sealing structure, penetration of moisture or oil into the phosphor layer 140 may further be prevented.

The sealing tape 220 may be attached along a surface of the sensor assembly 110 on which the sealant 210 is formed. In this regard, for example, the sealing tape 220 may be formed such that the sealing tape 220 covers an upper surface and side surfaces of the sealant 210, an upper surface of an edge of the sensor substrate 120, side surfaces of the sensor substrate 120 and the driving circuit board 130, and a lower surface of an edge of the driving circuit board 130.

Here, a portion of the sealing tape 220 attached to the lower surface of the driving circuit board 130 may be configured to be in contact with a ground terminal of the driving circuit board 130. The sealing tape 220 may be formed of a shielding material having a characteristic of shielding electromagnetic waves.

By attaching the sealing tape 220 in this manner, noise at the front side of the sensor substrate 120 may be minimized. Furthermore, the sealing tape 220 may perform a function of preventing surface scratches of the phosphor layer 140.

For example, the first waterproof film 230 may be formed such that the first waterproof film 230 covers the entire outer surface of the sensor assembly 110 to which the sealing tape 220 is attached.

In this regard, for example, a material for the first waterproof film 230 may be coated on the entire outer surface of the sensor assembly 110 to which the sealing tape 220 is attached. Accordingly, the upper surface, the side surfaces, and the lower surface of the sensor assembly 110 to which the sealing tape 220 is attached may be completely sealed by the first waterproof film 230.

The first waterproof film 230 may be formed of, for example, parylene. In this case, the first waterproof film 230 may be formed of at least one selected from parylene C and parylene N.

For example, the first waterproof film 230 may be formed as a single film of parylene C. In this case, the first waterproof film may have a thickness of approximately equal to or less than 15 µm.

As another example, the first waterproof film 230 may be formed as a double film (or a hybrid film) of parylene N and parylene C. In this case, in the first waterproof film 230, a primary waterproof film of parylene N may be formed first and may have a thickness of approximately equal to or less than 2 µm, and then a secondary waterproof film of parylene C may be formed and may have a thickness of approximately 10 µm.

By forming the first waterproof film 230 as described above, fine holes or the like that may exist during formation of the sealant 210 and sealing tape 220 described above may be filled. Furthermore, the first waterproof film 230 has excellent resistance characteristic to gas and chemicals, thereby preventing penetration of gas and chemicals.

For example, the second waterproof film 240 may be formed such that the second waterproof film 240 covers the front surface (or the upper surface) of the sensor assembly 110 sealed by the first waterproof film 230. As another example, the second waterproof film 240 may be formed such that the second waterproof film 240 covers an entire outer surface of the first waterproof film 230.

In this regard, for example, a material for the second waterproof film 240 may be coated on a front surface of the first waterproof film 230. Accordingly, the front side of the sensor assembly 110 may be sealed by the first waterproof film 230 and the second waterproof film 240.

The second waterproof film 240 may be formed of a material different from the material of the first waterproof film 230. For example, the second waterproof film 240 may be formed of silicone or epoxy. Here, the second waterproof film 240 may be formed by applying a liquid material or by a spraying method.

By additionally forming the second waterproof film 240 in this manner, moisture permeation may further be prevented. In addition, by forming the second waterproof film 240, flatness of a front portion of the sensor substrate 120 may be substantially increased and, accordingly, image distortion due to poor surface condition may be minimized.

Meanwhile, materials forming the first waterproof film 230 and second waterproof film 240 described above may be exchanged with each other. In other words, the first waterproof film 230 may be formed of silicone or epoxy, and the second waterproof film 240 may be formed of parylene.

The detector module 100 configured as described above may be inserted into and accommodated in the boot 400. In this regard, the boot 400 may have an accommodation space therein, and the detector module 100 may be inserted into the accommodation space in the boot 400.

Here, the boot 400 may be formed of a waterproof material, for example, silicone, but is not limited thereto.

After the detector module 100 is inserted into the boot 400, a filler 300 may be injected into the accommodation space of the boot 400. Accordingly, the accommodation space of the boot 400 into which the detector module 100 is inserted may be filled with the filler 300. In other words, a space between an inner surface of the boot 400 and the detector module 100 may be filled with the filler 300.

After the filler 300 is injected in this manner, for example, a curing process may be performed in a vacuum chamber so as to cure the filler 300.

By filling the accommodation space in the boot 400 into which the detector module 100 is inserted with the filler 300, air, gas, and empty space that may affect the detector module 100 in the boot 400 may be minimized.

The filler 300 may be formed of, for example, a waterproof material such as a polymer material substantially having no oil content. For example, the filler 300 may be formed of epoxy, but is not limited thereto. Meanwhile, epoxy forming the filler 300 may have the same composition as the second waterproof film 240, but is not limited thereto.

The detector module 100 accommodated in the boot 400 as described above may be housed by the case 500.

In this regard, the case 500 may include an upper case (or a first case) 510 and a lower case 520, and an accommodation space may be provided in the case 500 by coupling the upper case 510 and the lower case 520 to each other.

In the internal accommodation space of the case 500, the detector module 100 coupled with the boot 400 may be inserted and accommodated.

In this regard, for example, the detector module 100 coupled with the boot 400 may be seated in the lower case 520, and then the upper case 510 may be coupled to the lower case 520.

Here, in order to couple and fix the upper case 510 and the lower case 520 to each other, a coupling member (or a sealing member) 550 may be used. In this regard, the coupling member 550 may be formed by coating the coupling member 550 along an inner coupling portion of the upper case 510 and the lower case 520.

The coupling member 550 may be formed of a waterproof material, for example, epoxy, but is not limited thereto.

The coupling member 550 may be disposed so as to be in close contact with (or in contact with) a corresponding side surface of the boot 400.

Meanwhile, a buffer member 560 may be interposed between a front surface of the boot 400 and an inner surface of the case 500 corresponding thereto. The buffer member 560 may be formed of a waterproof material, for example, epoxy, in the same manner as the coupling member 550.

As described above, in the X-ray detector according to the present embodiment, the phosphor layer vulnerable to moisture is surrounded by the plurality of sealing members and is tightly sealed and, furthermore, the detector module sealed by the sealing members may be disposed in the boot and then is filled and sealed with the filler.

As described above, since the X-ray detector includes the sealing structure capable of substantially completely and firmly sealing the phosphor layer, penetration of moisture or oil into the phosphor layer may be effectively prevented.

Accordingly, defects due to penetration of moisture or oil during a manufacturing process are prevented, thereby maximizing a yield of good products.

### <Second Embodiment>

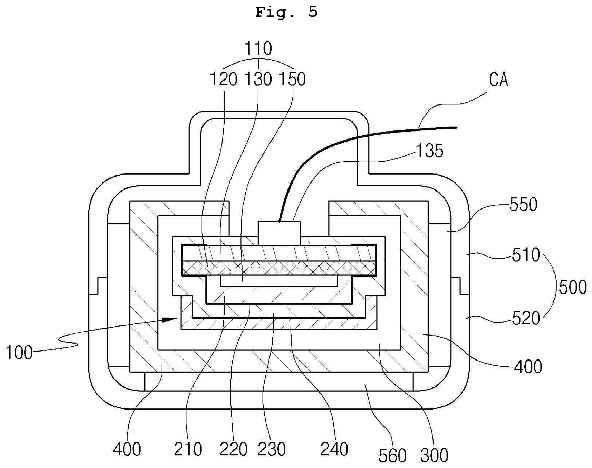

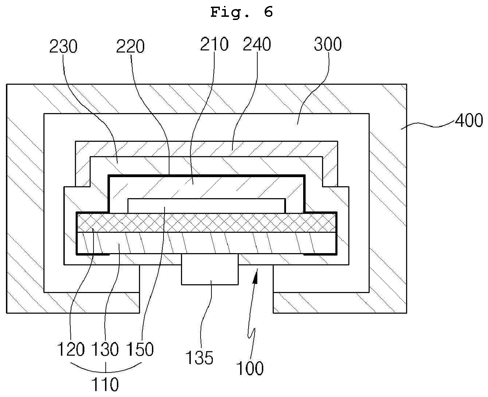

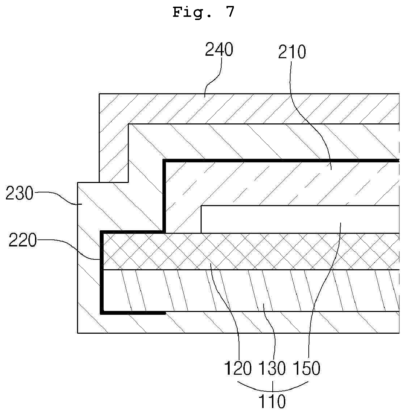

FIG. 5 is a cross-sectional view schematically illustrating a configuration of the X-ray detector according to a second embodiment of the present disclosure. FIG. 6 is a cross-sectional view schematically illustrating the detector module of the X-ray detector according to the second embodiment of the present disclosure. FIG. 7 is a cross-sectional view schematically illustrating the sensor assembly and the sealing structure sealing the sensor assembly according to the second embodiment of the present disclosure.

In the present embodiment, a detailed description of configurations identical or similar to those of the first embodiment described above may be omitted.

Referring to FIG. 5 to FIG. 7, the X-ray detector 10 according to the present embodiment, unlike the first embodiment, may be configured as a direct conversion type X-ray detector that directly detects incident X-rays and converts the incident X-rays into an electrical signal.

The X-ray detector 10 may include the detector module 100, the boot 400 (or a module cover), and the case 500 (or an outer case).

Here, the detector module 100 may include the sensor assembly 110 and the plurality of sealing members sealing the sensor assembly 110.

First, the sensor assembly 110 may include the sensor substrate 120, a photoelectric material layer (or a photoconductive layer) 150, and the driving circuit board 130.

Since the X-ray detector 10 of the present embodiment is configured as a direct conversion type X-ray detector unlike the first embodiment, the X-ray detector 10 does not include the phosphor layer of the first embodiment, and instead, the photoelectric material layer 150 that directly detects X-rays and generates an electrical signal may be disposed.

The photoelectric material layer 150 may be formed on the upper surface of the sensor substrate 120 and, for example, may be formed of perovskite, but is not limited thereto.

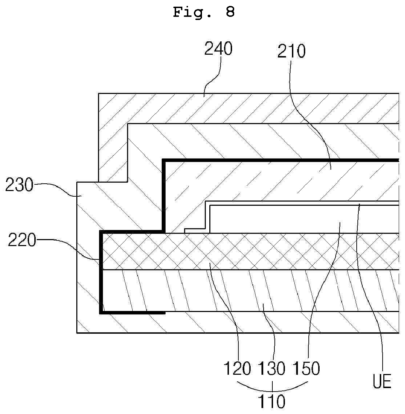

Meanwhile, although not specifically illustrated, a lower electrode may be formed below the photoelectric material layer 150 for each pixel. In addition, as illustrated in FIG. 8, the upper electrode UE may be formed on the photoelectric material layer 150.

Meanwhile, the sensor substrate 120 may be formed of a CMOS substrate or a TFT substrate.

The driving circuit board 130 may be disposed at a rear side of the sensor substrate 120. In other words, the driving circuit board 130 may be positioned opposite to the photoelectric material layer 150 with the sensor substrate 120 interposed therebetween. The driving circuit for driving the sensor substrate 120 may be mounted on the driving circuit board 130.

Meanwhile, the connector 135 for connection with the external system circuit may be mounted on the driving circuit board 130. The cable CA may be connected to the connector 135, and the driving circuit board 130 may be electrically connected to the external system circuit through the cable CA.

As described above, the sensor assembly 110 according to the present embodiment may be configured as a stacked structure of the driving circuit board 130, the sensor substrate 120, and the photoelectric material layer 150.

Meanwhile, the photoelectric material layer 150 may be formed such that an edge of a front surface of the sensor substrate 120 is exposed. In other words, an edge area of the sensor substrate 120 is not covered by the photoelectric material layer 150, and an area inside the edge region may be covered by the photoelectric material layer 150.

In this regard, for example, the photoelectric material layer 150 may be disposed corresponding to an active area of the sensor substrate 120, and a non-active area positioned at an edge of the sensor substrate 120 may be exposed without being covered by the photoelectric material layer 150.

The sensor assembly 110 configured as described above may be configured to be sealed by the plurality of sealing members.

In this regard, for example, the sealant 210, the sealing tape (or the electromagnetic wave shielding sheet) 220, the first waterproof film (or the first coating film) 230, and the second waterproof film (or the second coating film) 240 may be disposed from the sensor assembly 110 toward an outward direction.

The sealant 210 may be formed such that the sealant 210 covers the photoelectric material layer 150. In this regard, for example, a sealant material may be deposited through a sputtering process in a vacuum state. In this manner, the sealant 210 may directly seal the photoelectric material layer 150.

Here, the sealant material may be a metal, for example, aluminum or gold, but is not limited thereto.

Accordingly, the sealant 210 may cover an upper surface and side surfaces of the photoelectric material layer 150, thereby sealing the photoelectric material layer 150 from the outside. Meanwhile, when the sealant 210 is formed in a vacuum state, additional penetration of moisture or oil may be prevented, and bubbles inside the photoelectric material layer 150 may be removed. Here, the sealant 210 may serve as an upper electrode of the photoelectric material layer 150. That is, since the sealant 210 is a metal material that is directly in contact with the photoelectric material layer 150, the sealant 210 may serve as a common upper electrode to which a bias voltage (or a reverse voltage) is applied to the photoelectric material layer 150 together with the lower electrode provided for each pixel below the photoelectric material layer 150.

Meanwhile, in the present embodiment, as illustrated in FIG. 8, the upper electrode UE of the light detecting element may be separately provided and may extend outward on the photoelectric material layer 150. In this regard, the upper electrode UE of the light detecting element to which the bias voltage (or the reverse voltage) is applied may be formed substantially over the entire active area, and the upper electrode UE may extend outward from the photoelectric material layer 150 positioned below the upper electrode UE.

The upper electrode UE that extends outward in this manner may be covered by the sealant 210 and may be in contact with the sealant 210.

Here, the photoelectric material layer 150 may be doubly covered by the sealant 210 and the upper electrode UE, thereby having a more sealed state. Through such a sealing structure, penetration of moisture or oil into the photoelectric material layer 150 may be further prevented.

The sealing tape 220 may be attached along the surface of the sensor assembly 110 on which the sealant 210 is formed. In this regard, for example, the sealing tape 220 may be formed such that the sealing tape 220 covers an upper surface and side surfaces of the sealant 210, an upper surface of an edge of the sensor substrate 120, side surfaces of the sensor substrate 120 and the driving circuit board 130, and a lower surface of an edge of the driving circuit board 130.

Here, a portion of the sealing tape 220 attached to the lower surface of the driving circuit board 130 may be configured to be in contact with a ground terminal of the driving circuit board 130. The sealing tape 220 may be formed of a shielding material having a characteristic of shielding electromagnetic waves.

By attaching the sealing tape 220 in this manner, noise at the front side of the sensor substrate 120 may be minimized. Furthermore, the sealing tape 220 may perform a function of preventing surface scratches of the photoelectric material layer 150.

For example, the first waterproof film 230 may be formed such that the first waterproof film 230 covers the entire outer surface of the sensor assembly 110 to which the sealing tape 220 is attached.

In this regard, for example, a material for the first waterproof film 230 may be coated on the entire outer surface of the sensor assembly 110 to which the sealing tape 220 is attached. Accordingly, the upper surface, the side surfaces, and the lower surface of the sensor assembly 110 to which the sealing tape 220 is attached may be completely sealed by the first waterproof film 230.

The first waterproof film 230 may be formed of, for example, parylene. Here, the first waterproof film 230 may be formed of at least one selected from parylene C and parylene N.

For example, the first waterproof film 230 may be formed as a single film of parylene C. In this case, the first waterproof film may have a thickness of approximately equal to or less than 15 µm.

As another example, the first waterproof film 230 may be formed as a double film (or a hybrid film) of parylene N and parylene C. In this case, in the first waterproof film 230, a primary waterproof film of parylene N may be formed first and may have a thickness of approximately equal to or less than 2 µm, and then a secondary waterproof film of parylene C may be formed and may have a thickness of approximately 10 µm.

By forming the first waterproof film 230 as described above, fine holes or the like that may exist during formation of the sealant 210 and sealing tape 220 described above may be filled. Furthermore, the first waterproof film 230 has excellent resistance characteristic to gas and chemicals, thereby preventing penetration of gas and chemicals.

For example, the second waterproof film 240 may be formed such that the second waterproof film 240 covers the front surface (or the upper surface) of the sensor assembly 110 sealed by the first waterproof film 230. As another example, the second waterproof film 240 may be formed such that the second waterproof film 240 covers an entire outer surface of the first waterproof film 230.

In this regard, for example, a material for the second waterproof film 240 may be coated on a front surface of the first waterproof film 230. Accordingly, the front side of the sensor assembly 110 may be sealed by the first waterproof film 230 and the second waterproof film 240.

The second waterproof film 240 may be formed of a material different from the material of the first waterproof film 230. For example, the second waterproof film 240 may be formed of silicone or epoxy. Here, the second waterproof film 240 may be formed by applying a liquid material or by a spraying method.

By additionally forming the second waterproof film 240 in this manner, moisture permeation may further be prevented. In addition, by forming the second waterproof film 240, flatness of a front portion of the sensor substrate 120 may be substantially increased and, accordingly, image distortion due to poor surface condition may be minimized.

Meanwhile, materials forming the first waterproof film 230 and second waterproof film 240 described above may be exchanged with each other. In other words, the first waterproof film 230 may be formed of silicone or epoxy, and the second waterproof film 240 may be formed of parylene.

The detector module 100 configured as described above may be inserted into and accommodated in the boot 400. In this regard, the boot 400 may have an accommodation space therein, and the detector module 100 may be inserted into the accommodation space in the boot 400.

Here, the boot 400 may be formed of a waterproof material, for example, silicone, but is not limited thereto.

After the detector module 100 is inserted into the boot 400, the filler 300 may be injected into the accommodation space of the boot 400. Accordingly, the accommodation space of the boot 400 into which the detector module 100 is inserted may be filled with the filler 300. In other words, a space between an inner surface of the boot 400 and the detector module 100 may be filled with the filler 300.

After the filler 300 is injected in this manner, for example, a curing process may be performed in a vacuum chamber so as to cure the filler 300.

By filling the accommodation space in the boot 400 into which the detector module 100 is inserted with the filler 300, air, gas, and empty space that may affect the detector module 100 in the boot 400 may be minimized.

The filler 300 may be formed of, for example, a waterproof material such as a polymer material substantially having no oil content. For example, the filler 300 may be formed of epoxy, but is not limited thereto. Meanwhile, epoxy forming the filler 300 may have the same composition as the second waterproof film 240, but is not limited thereto.

The detector module 100 accommodated in the boot 400 as described above may be housed by the case 500.

In this regard, the case 500 may include the upper case (or the first case) 510 and the lower case 520, and an accommodation space may be provided in the case 500 by coupling the upper case 510 and the lower case 520 to each other.

In the internal accommodation space of the case 500, the detector module 100 coupled with the boot 400 may be inserted and accommodated.

In this regard, for example, the detector module 100 coupled with the boot 400 may be seated in the lower case 520, and then the upper case 510 may be coupled to the lower case 520.

Here, in order to couple and fix the upper case 510 and the lower case 520 to each other, the coupling member (or the sealing member) 550 may be used. In this regard, the coupling member 550 may be formed by coating the coupling member 550 along an inner coupling portion of the upper case 510 and the lower case 520.

The coupling member 550 may be formed of a waterproof material, for example, epoxy, but is not limited thereto.

The coupling member 550 may be disposed so as to be in close contact with (or in contact with) a corresponding side surface of the boot 400.

Meanwhile, the buffer member 560 may be interposed between a front surface of the boot 400 and an inner surface of the case 500 corresponding thereto. The buffer member 560 may be formed of a waterproof material, for example, epoxy, in the same manner as the coupling member 550.

As described above, in the X-ray detector according to the present embodiment, the photoelectric material layer vulnerable to moisture is surrounded by the plurality of sealing members and is tightly sealed and, furthermore, the detector module sealed by the sealing members may be disposed in the boot and then filled and sealed with the filler.

As described above, since the X-ray detector includes the sealing structure capable of substantially completely and firmly sealing the photoelectric material layer, penetration of moisture or oil into the photoelectric material layer may be effectively prevented.

Accordingly, defects due to penetration of moisture or oil during a manufacturing process are prevented, thereby maximizing a yield of good products.

The above-described embodiments of the present disclosure are examples of the present disclosure, and free modification is possible within the scope included in the spirit of the present disclosure. Accordingly, the present disclosure includes modifications of the present disclosure within the scope of the appended claims and the equivalents thereof.

## Claims

1. An X-ray detector comprising:
a sensor assembly comprising a sensor substrate and a phosphor layer or a photoelectric material layer disposed on a front surface of the sensor substrate;
a first waterproof film coating the sensor assembly; and
a second waterproof film coating the first waterproof film, formed of a material different from a material of the first waterproof film.

2. The X-ray detector of claim 1, wherein the first waterproof film surrounds an entirety of the sensor assembly, and the second waterproof film covers a front side of the first waterproof film.

3. The X-ray detector of claim 1, further comprising:
an upper electrode formed below the phosphor layer or on the photoelectric material layer,
wherein the upper electrode extends outward from the phosphor layer or the photoelectric material layer.

4. The X-ray detector of claim 1, wherein one of the first waterproof film and the second waterproof film is formed of parylene, and the other of the first waterproof film and the second waterproof film is formed of silicone or epoxy.

5. The X-ray detector of claim 4, wherein the one of the first waterproof film and the second waterproof film that is formed of parylene is configured as a single film of parylene C or a double film of parylene N and parylene C.

6. The X-ray detector of claim 1, further comprising:
a sealant covering the phosphor layer or the photoelectric material layer.

7. The X-ray detector of claim 6, wherein the sealant is formed of a metal material, and is a common upper electrode configured to apply a bias voltage to the photoelectric material layer.

8. The X-ray detector of claim 6, further comprising:
an electromagnetic wave shielding sheet attached along a surface of the sealant and a surface of the sensor assembly.

9. The X-ray detector of claim 1, further comprising:
a boot having an accommodation space into which the sensor assembly coated with the first water proof film and the second water proof film is inserted, the boot being formed of a waterproof material; and
a filler filling the accommodation space into which the sensor assembly is inserted, the filler being formed of a waterproof material.

10. The X-ray detector of claim 9, further comprising:
a case comprising a first case and a second case that define an internal space where the boot into which the sensor assembly is inserted is accommodated; and
a coupling member coupling the first case and the second case.
